# EUROPÄISCHE PATENTSCHRIFT

(11) **EP 2 215 008 B1**
(45) Veröffentlichungstag und Bekanntmachung des Hinweises auf die Patenterteilung: **07.03.2012**
(21) Anmeldenummer: 08804854.1
(22) Anmeldetag: 29.09.2008
(51) Int. Cl.: B81C 1/00, H01L 23/495

(54) **MODULGEHÄUSE UND VERFAHREN ZUR HERSTELLUNG EINES MODULGEHÄUSES**
MODULE HOUSING AND METHOD FOR PRODUCING A MODULE HOUSING
BOÎTIER DE MODULE ET PROCÉDÉ POUR PRODUIRE UN BOÎTIER DE MODULE

(30) Priorität: 30.10.2007 DE 102007051870
(43) Veröffentlichungstag der Anmeldung: 11.08.2010
(73) Patentinhaber: Robert Bosch GmbH, 70442 Stuttgart (DE)
(72) Erfinder: LUDWIG, Ronny, 72770 Reutlingen (DE)
(86) Internationale Anmeldenummer: PCT/EP2008/062992
(87) Internationale Veröffentlichungsnummer: WO 2009/056414

(56) Entgegenhaltungen:
- EP-A- 1 463 104
- WO-A-2007/080785
- DE-C1- 19 752 196
- US-A1- 2009 001 532
- US-B1- 6 704 204

## Beschreibung

### Stand der Technik

Die Erfindung geht von einem Modulgehäuse nach dem Obergriff des Anspruchs 1 aus.

Solche Modulgehäuse sind allgemein bekannt. Beispielsweise ist aus der Druckschrift DE 10 2004 058 815 A1 ein Chipmodul mit einem Gehäusekörper und einem "Leadframe" bekannt, wobei der Gehäusekörper ein Bauelement, insbesondere eine Halbleiterbauelement, aufweist und der Leadframe in einem Teilbereich vom Gehäusekörper formschlüssig umschlossen ist. In einem Herstellungsprozess wird zunächst das Bauelement auf dem "Leadframe" montiert und anschließend zur Erzeugung des Gehäusekörpers mit Epoxid umspritzt. Anschließend wird der Leadframe gestanzt, so dass einzelne Chipmodule entstehen. Eine Umschließung des Gehäusekörpers des Chipmoduls und eines zweiten Teilbereichs des Leadframes durch eine Umspritzung mit einem Außengehäuse ist nicht vorgesehen, so dass zusätzliche Verfahrensschritte zur Kontaktierung des Bauelements bzw. des Chipmoduls, typischerweise durch Montage- und Lötprozesse auf einer Leiterplatte, sowie weitere Verfahrensschritte zur Bildung eines Schutzgehäuses oder zum Einsatz des Gehäusekörpers in ein Schutzgehäuse notwendig sind.

Ein weiteres Modulgehäuse ist aus der Druckschrift EP 1 463 104 A2 bekannt.

### Offenbarung der Erfindung

Das erfindungsgemäße Modulgehäuse und das erfindungsgemäße Verfahren zur Herstellung eines Modulgehäuses gemäß den nebengeordneten Ansprüchen haben den Vorteil, dass gegenüber dem Stand der Technik eine Integration von wenigstens einem Bauelement mit vergleichsweise gut beherrschbaren Prozessschritten in ein Außengehäuse ermöglicht wird, wobei kundenspezifische und/oder verwendungsspezifische Anforderungen an die Formgebung des Außengehäuses und/oder die Art und Weise der elektrischen Kontaktierung in einfacher Weise und mit minimalen Prozesskostenaufwand realisierbar sind. Dies wird einerseits durch die formschlüssige und/oder stoffschlüssige Verbindung zwischen dem Außengehäuse und dem Innengehäuse erreicht, so dass gegenüber dem Stand der Technik kein zusätzliches Trägerelement benötigt wird, welches eine Herstellung und eine Montage in zusätzlichen kostenintensiven Verfahrensschritten erfordert. Die Herstellung des Außengehäuses in einem vergleichsweise gut beherrschbaren Spritzguss- oder Moldprozess ermöglicht eine variable und flexible Formgebung des Außengehäuses, so dass die spezifischen Anforderungen an das Außengehäuse in einfacher Weise realisierbar sind. Andererseits ist weist das Verbindungselement im dritten Teilbereich die elektrischen Steckerkontakte auf, so dass keine zusätzlichen Elemente zur Kontaktierung des Verbindungselements bzw. des wenigstens einen Bauelements, insbesondere über einen steckbaren Kontakt, benötigt werden. Das Verbindungselement fungiert somit besonders vorteilhaft gleichzeitig zur mechanischen Fixierung und zur elektrischen Kontaktierung des Bauelements, so dass im Vergleich zum Stand der Technik keinerlei Platinen, Leiterplatten oder zusätzliche Stecker erforderlich sind. Vorteilhaft ist eine einteilige Verbindung von Steckerkontakt und eines Bauelementkontaktes vorgesehen, so dass keine zusätzlichen Leiterbahnen und/oder elektrischen Kontakte, welche in zusätzlichen Verfahrensschritten kontaktiert werden müssten, erforderlich. Die formschlüssige Umschließung des Innengehäuses durch das Außengehäuse gewährleistet weiterhin eine maximale Schutz- und Arretierungsfunktion des Innengehäuses, da das Innengehäuse von allen Seiten mechanisch fixiert wird. Im Stand der Technik wird das Innengehäuse lediglich von einer Grundseite aus durch eine stoffschlüssige Verbindung arretiert.

Gemäß einer weiteren bevorzugten Weiterbildung weist das Außengehäuse einen Stecker auf, welcher die elektrischen Steckerkontakte zumindest teilweise umhüllt, wobei insbesondere verschiedene Formgebungen des elektrischen Steckerkontaktes durch entsprechende Stanz-Biege-Prozesse realisierbar sind. Vorteilhaft sind somit Außengehäuse und Stecker einteilig verbunden und in einem einzigen vergleichsweise einfachen Verfahrensschritt herstellbar. Der Prozess des Umspritzens und/oder die Realisierung unterschiedlicher Formgebungen des elektrischen Steckerkontaktes erlauben in einfacher Weise die Realisation unterschiedlichster Formgebungen des Außengehäuses und daher auch unterschiedlichster Steckerformen, insbesondere genormte und/oder standardisierte Steckertypen.

Gemäß einer bevorzugten Weiterbildung weist das Verbindungselement in dem dritten Teilbereich eine elektrische und/oder mechanische Verbindung zu weiteren Steckerkontakten auf, so dass besonders vorteilhaft die weiteren Steckerkontakte in Materialstärken realisierbar sind, welche von der Materialstärke oder des Materialtyps des Verbindungselements abweichen. Somit ist beispielsweise eine einfache und kostengünstige Herstellung eines vergleichsweise dünnen Verbindungselementes in einem Stanz-Biege-Prozess möglich, während zur Realisierung einer bestimmten Steckernorm mit einer entsprechend geforderte Materialstärke des Steckerkontaktes ein weiteres Material der geforderten Stärke als weiterer Steckerkontakt verwendet wird. Bevorzugt wird der weitere Steckerkontakt elektrisch leitend mit dem Verbindungselement, insbesondere durch eine stoffschlüssige, kraftschlüssige und/oder formschlüssige Verbindung, verbunden.

Gemäß einer bevorzugten Weiterbildung weist das wenigstens eine Bauelement einen elektrischen und/oder mechanischen ersten Kontakt zum Verbindungselement auf und/oder ist das Verbindungselement in einem zweiten Teilbereich formschlüssig von dem Außengehäuse umschlossen, so dass das Verbindungselement vorteilhaft gleichzeitig zur mechanischen Fixierung des Bauelements und zur elektrischen Kontaktierung des Bauelements fungiert. Vorteilhaft werden somit keinerlei zusätzlichen Trägerelemente und/oder Leiterplatten bzw. Platinen zur Kontaktierung des Bauelements benötigt, welche vergleichsweise kostenintensive Herstellungsverfahren und Montageverfahren erfordern.

Gemäß der Erfindung umfasst das Verbindungselement wenigstens zwei elektrisch leitfähige Leiterbahnen, wobei sich die Leiterbahnen jeweils zumindest teilweise über den ersten, den zweiten und den dritten Teilbereich des Verbindungselements erstrecken. Vorteilhaft wird somit eine einfache elektrische Kontaktierung des Bauelements durch das Verbindungselement ermöglicht. Im Vergleich zum Stand der Technik wird der Kontaktierungsaufwand erheblich reduziert, da lediglich ein einziges Bauteil zur Herstellung einer leitfähigen Verbindung vom Steckerkontakt bis zum Bauelement verwendet wird und somit die kostenintensive Herstellung, Montage und Kontaktierung von Leiterplatten oder Platinen eingespart wird.

Gemäß einer weiteren bevorzugten Weiterbildung umfassen das Innengehäuse und/oder das Außengehäuse ein Moldgehäuse oder ein Spritzgussgehäuse und/oder das Bauelement wenigstens einen Halbleiterchip und/oder wenigstens ein passives elektrisches Bauelement. Die Verwendung von Moldgehäusen bzw. Spritzgussgehäusen ermöglichen eine einfache und variable Formgestaltung des Innen- und Außengehäuses, insbesondere da der Moldprozess (bspw. "injection molding") und/oder der Spritzgussprozess vergleichsweise gut beherrschbar ist. Vorteilhaft umfasst das Bauelement oder das Innengehäuse eine mehrteilige Anordnung von Halbleiterchips und/oder passiven Bauelementen, insbesondere eines Sensorchips und/oder eines ASICs, welche auf dem ersten Teilbereich des Verbindungselements montiert sind, so dass bevorzugt auch komplexe und mehrteilige elektrische Schaltungen innerhalb des Innengehäuses ermöglicht werden. Besonders bevorzugt weist der erste Teilbereich des Verbindungselements mehrere elektrisch voneinander isolierte bzw. entflechtete Leiterbahnen zur Aufnahme und Verschaltung mehrerer Halbleiterchips und/oder mehrerer passiver Bauelemente auf, wobei ganz besonders bevorzugt der "Footprint" der jeweiligen Halbleiterchips und/oder der passiven Bauelemente in das Verbindungselement integriert ist.

Ein weiterer Gegenstand der vorliegenden Erfindung ist ein Verfahren zur Herstellung eines Modulgehäuses, wobei in einem ersten Verfahrensschritt das wenigstens eine Bauelement auf dem Verbindungselement montiert wird, wobei in einem zweiten Verfahrensschritt das wenigstens eine Bauelement und der erste Teilbereich des Verbindungselements zur Erzeugung des Innengehäuses umspritzt wird und wobei in einem dritten Verfahrensschritt das Innengehäuse und zumindest teilweise das Verbindungselement zur Erzeugung des Außengehäuses umspritzt wird. Vorteilhaft wird somit in lediglich drei vergleichsweise einfachen und gut zu beherrschenden Verfahrensschritten ein Modulgehäuse mit variabler Formgebung des Außengehäuses ermöglicht. Insbesondere ist eine Verwendung von zusätzlichen Trägerelementen und Leiterplatten bzw. Platinen nicht erforderlich. Das Bauelement wird bevorzugt auf das Verbindungselement gelötet und/oder geklebt, wobei besonders bevorzugt das Verbindungselement im Bereich des Bauelements den "Footprint" des Bauelements aufweist.

Gemäß einer weiteren bevorzugten Weiterbildung wird zwischen dem ersten und dem zweiten Verfahrensschritt ein vierter Verfahrensschritt zum elektrischen Kontaktieren des wenigstens einen Bauelements, insbesondere mittels eines Bondvorgangs, durchgeführt. Vorteilhaft wird somit die elektrische Verschaltung des Bauelements und insbesondere mehrerer Bauelemente untereinander ermöglicht, so dass bevorzugt komplexe elektrische Schaltungen mit mehreren Halbleiterchips und/oder mehreren passiven Bauelementen realisierbar sind, wobei besonders bevorzugt das Verbindungselement im ersten Teilbereich eine Mehrzahl von Leiterbahnen aufweist, welche der optimalen Kontaktierung mehrerer Bauelemente bzw. deren "Footprints" angepasst sind.

Gemäß einer weiteren bevorzugten Weiterbildung wird zwischen dem zweiten und dem dritten Verfahrensschritt ein fünfter Verfahrensschritt zum Stanzen und/oder Biegen des Verbindungselements, bevorzugt im dritten Teilbereich des Verbindungselements zur Erzeugung der Steckerkontakte, durchgeführt. Vorteilhaft werden somit in einfacher Weise die Steckerkontakte ohne zusätzliche Bauteile realisiert, wobei eine variable Formanpassung der Steckerkontakte im Biege- und/oder Stanzvorgang spezifische Steckerkontaktanforderungen, d.h. für genormte und/oder standardisierte Steckertypen, emöglicht. Bevorzugt werden im Biegevorgang beispielsweise Klemm- und/oder Federbiegestellen im dritten Teilbereich des Verbindungselements gebildet, so dass eine erhöhte Verbindungsfestigkeit im Falle einer Steckverbindung zwischen dem Stecker und einem entsprechenden Steckergegenstück erzielt wird. Besonders vorteilhaft ist im Stanzprozess gleichzeitig eine Abtrennung von überschüssigem Verbindungselementmaterials vom Verbindungselement vorgesehen.

Gemäß einer weiteren bevorzugten Weiterbildung werden im ersten Verfahrensschritt eine Vielzahl von Bauelementen auf einem Verbund, insbesondere einem Leadframe-Verband, montiert und im zweiten Verfahrensschritt die Vielzahl von Bauelementen zur Erzeugung einer Vielzahl von Innengehäusen jeweils umspritzt, wobei im fünften Verfahrensschritt der Verbund derart gestanzt wird, dass eine Vielzahl der Verbindungselemente teilweise umschlossen von einem Innengehäuse gebildet werden. Vorteilhaft wird somit eine vergleichsweise kostengünstige Produktion einer Vielzahl von Modulgehäusen gleichzeitig ermöglicht. Besonders bevorzugt ist die gleichzeitige Herstellung einer Vielzahl von Innengehäusen, welche die ersten Teilbereiche der Verbindungselemente umschließen und jeweils wenigstens das eine Bauelement aufweisen, wobei das Außengehäuse im dritten Verfahrensschritt jeweils mit individuellen Formgebungen je nach Anforderung gefertigt wird, so dass beispielsweise eine Vielzahl gleicher Modulgehäuse, insbesondere Sensoren, mit unterschiedlichen Außengehäusen herstellbar sind.

Gemäß einer weiteren bevorzugten Weiterbildung umfasst der zweite Verfahrensschritt einen Moldprozess, wobei bevorzugt ein "injection molding"-Prozess durchgeführt wird und/oder umfasst der dritte Verfahrensschritt ein Spritzgussprozess, wobei bevorzugt ein Umspritzen mit einem Kunststoffprozess durchgeführt wird. Vorteilhaft werden somit in einem vergleichsweise gut beherrschbaren und kostengünstigen Herstellungsprozess in einfacher Weise variable Gehäuseformen realisiert.

Ausführungsbeispiele der Erfindung sind in den Zeichnungen dargestellt und in der nachfolgenden Beschreibung näher erläutert.

### Kurze Beschreibung der Zeichnung

Es zeigen
**Figur 1** eine schematische Aufsicht und eine schematische Seitenansicht eines Modulgehäuses gemäß einer ersten Ausführungsform der vorliegenden Erfindung,
**Figur 2a** bis **Figur 2g** schematische Darstellungen von weiteren Vorläuferstrukturen des Modulgehäuses gemäß weiteren Ausführungsformen der vorliegenden Erfindung,
**Figur 3** eine erste Vorläuferstruktur einer Mehrzahl von Modulgehäusen gemäß einer der weiteren Ausführungsformen,
**Figur 4** ein Innengehäuse eines Modulgehäuses gemäß einer der weiteren Ausführungsformen und
**Figur 5** Bauelemente des Innengehäuses eines Modulgehäuses gemäß einer der weiteren Ausführungsformen.

In den verschiedenen Figuren sind gleiche Teile im Wesentlichen mit den gleichen Bezugszeichen versehen und werden daher in der Regel auch jeweils nur einmal benannt.

### Ausführungsform(en) der Erfindung

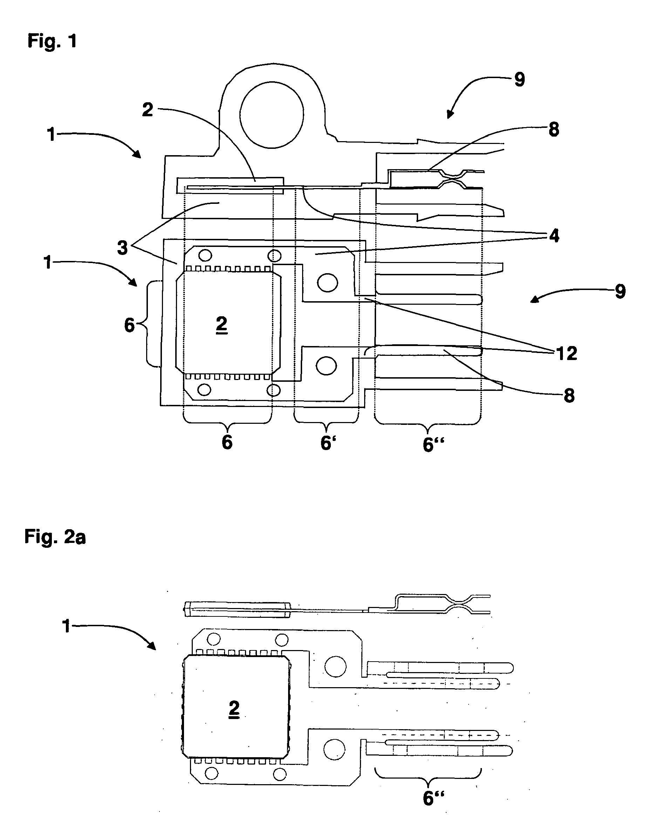

In **Figur 1** ist eine schematisch Aufsicht bzw. Durchsicht und eine schematische Seitenansicht bzw. seitliche Durchsicht eines Modulgehäuses 1 gemäß einer ersten Ausführungsform der vorliegenden Erfindung dargestellt, wobei das Modulgehäuse 1 ein Innengehäuse 2, ein Außengehäuse 3 und ein Verbindungselement 4 aufweist, wobei das Innengehäuse 2 wenigstens ein Bauelement 5 aufweist und wobei das Verbindungselement 4 in einem ersten Teilbereich 6 von dem Innengehäuse 2 formschlüssig umschlossen ist und wobei ferner das Verbindungselement 4 in einem zweiten Teilbereich 6' und das Innengehäuse 2 vollständig von dem Außengehäuse 3 jeweils formschlüssig umschlossen ist. Das Außengehäuse 3 umfasst ferner einen Stecker 9 zur Kontaktierung des Verbindungselements 4, wobei nicht abgebildete Bauelemente 5 elektrische und mechanische erste Kontakte 7 zum Verbindungselement 4 aufweisen und wobei das Verbindungselement 4 in einem dritten Teilbereich 6" als elektrischer Steckerkontakt 8 eines Steckers 9 fungiert. Zur elektrischen Kontaktierung der Bauelemente 5 umfasst das Verbindungselement 4 wenigstens zwei elektrisch leitfähige Leiterbahnen 12, welche sich über den ersten, zweiten und dritten Teilbereich 6, 6', 6" erstrecken. Das Innengehäuse 2 umfasst bevorzugt Moldgehäuse, welche durch "injection-molding"-Prozesse mit Epoxid hergestellt werden, das Außengehäuse 3 bevorzugt Kunststoffgehäuse, welche durch einen Spritzgussprozess hergestellt werden. Besonders bevorzugt weisen die Steckerkontakte 8 Klemm- und/oder Federbiegestellen im dritten Teilbereich 6" auf, so dass eine erhöhte Festigkeit im Falle einer Steckverbindung zwischen dem Stecker 9 und einem entsprechenden Steckergegenstück erzielt wird.

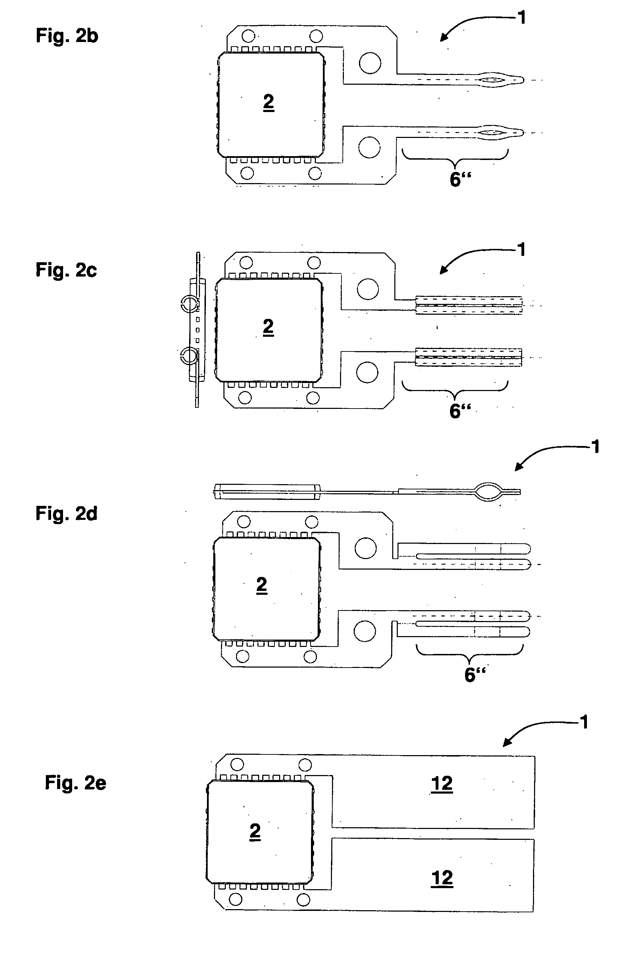

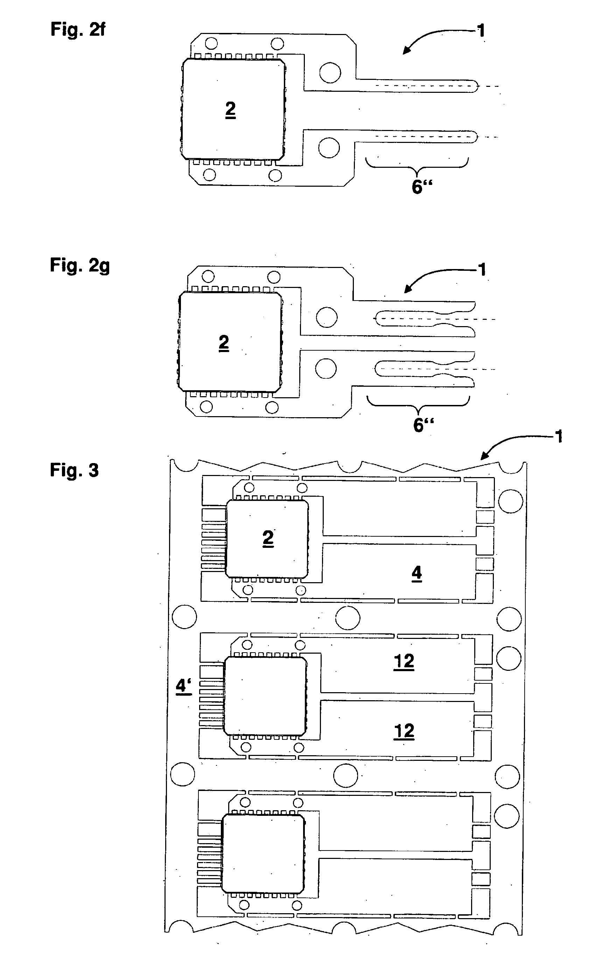

In **Figur 2a** bis **Figur 2g** sind schematische Darstellungen weiterer Vorläuferstrukturen des Modulgehäuses 1 gemäß weiteren Ausführungsformen der vorliegenden Erfindung dargestellt, welche im Wesentlichen identisch mit dem Modulgehäuse 1 gemäß der ersten Ausführungsform jeweils ohne Außengehäuse 3 sind, wobei lediglich die Form des Verbindungselementes 4 im dritten Teilbereich 6" in den weiteren Ausführungsformen derart variiert, dass eine Vielzahl von unterschiedlichen Steckerkontakten 8 für unterschiedliche Stecker 9 realisiert werden. Die **Figur 2e** zeigt eine schematische Darstellung einer weiteren Vorläuferstruktur, welche eine Grundausgangsform des Verbindungselements 4 darstellt, aus der alle möglichen Ausführungsformen von Steckerkontakten, beispielsweise der weiteren Ausführungsformen illustriert in den Figuren 2a bis 2g, durch Stand-Biege-Prozesse herstellbar sind.

In **Figur 3** ist eine erste Vorläuferstruktur einer Mehrzahl von Modulgehäusen 1 gemäß einer der weiteren Ausführungsformen dargestellt, welche als Grundausgangsformen in einem Leadframe-Verbund angeordnet sind, wobei eine Mehrzahl von nicht abgebildeten Bauelementen 5 im ersten Verfahrensschritt mit einem Verbund 4' von Verbindungselementen 4 montiert, bevorzugt in einem vierten Verfahrensschritt elektrisch kontaktiert und in einem zweiten Verfahrensschritt von einer Mehrzahl der Innengehäuse 2 umschlossen wurde. Der anhand der Vorläuferstruktur abgebildete Verbund 4' von Verbindungselementen 4 bzw. Leiterbahnen 12 wird in einem nachfolgendem fünften Verfahrensschritt derart ausgestanzt, dass einzelne Verbindungselemente 4 bzw. Leiterbahnen 12 mit jeweils einem Innengehäuse 2 entstehen, wobei bevorzugt gleichzeitig ein Biegen und/oder Stanzen des Verbindungselements 4 im dritten Teilbereich 6" zur Erzeugung der jeweiligen Steckerkontakte 8 vorgesehen ist. In einem nachfolgenden dritten Verfahrensschritt wird jeweils im Wesentlichen jedes Innengehäuse 2 und jeder zweite Teilbereich 6' des Verbindungselements 4 durch Umspritzen mit dem Außengehäuse 3 versehen, wobei das Außengehäuse 3 bevorzugt einen Stecker 9 aufweist und die äußere Formgebung des Außengehäuses 3 besonders bevorzugt jeweils variabel vorgesehen ist.

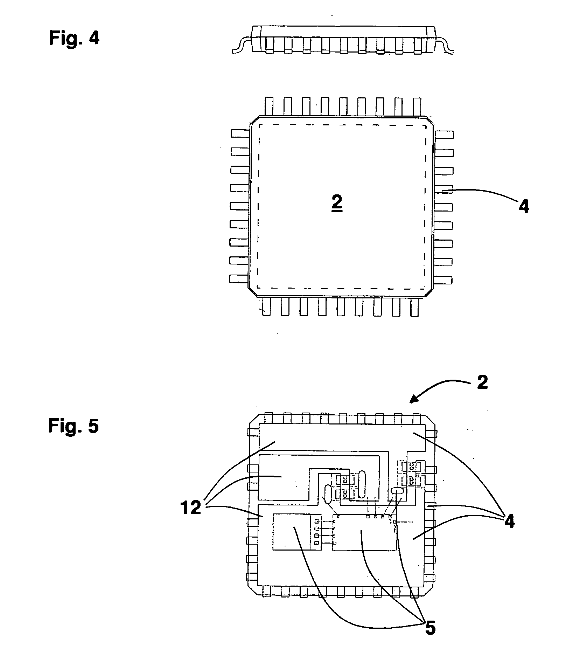

In **Figur 4** ist ein beispielhaftes Innengehäuse 2 eines Modulgehäuses 1 gemäß einer der weiteren Ausführungsformen dargestellt, wobei das Innengehäuse 1 ein Moldgehäuse ist, welches das Verbindungselement 4 im ersten Teilbereich 6 formschlüssig und insbesondere stoffschlüssig umschließt.

In **Figur 5** ist ebenfalls ein Innengehäuse 2 eines Modulgehäuses 1 gemäß einer der weiteren Ausführungsformen dargestellt, wobei das Innengehäuse 2 Bauelemente 5 aufweist, welche Halbleiterchips und passive Bauelemente umfasst. Die Bauelemente 5 sind auf dem Verbindungselement 4 montiert und mit den Leiterbahnen 12 des Verbindungselements 4 elektrisch kontaktiert. bevorzugt umfassen die Bauelemente 5 einen Bewegungssensor und einen ASIC.

## Patentansprüche

1. Modulgehäuse (1) mit einem Innengehäuse (2), einem Außengehäuse (3) und einem Verbindungselement (4), wobei das Innengehäuse (2) wenigstens ein Bauelement (5) aufweist und vollständig von dem Außengehäuse (3) formschlüssig umschlossen ist und wobei das Verbindungselement (4) in einem ersten Teilbereich (6) von dem Innengehäuse (2) formschlüssig umschlossen ist, **dadurch gekennzeichnet, dass** das Verbindungselement (4) in einem dritten Teilbereich (6") elektrische Steckerkontakte (8) aufweist, und dass das Verbindungselement (4) wenigstens zwei elektrisch leitfähige Leiterbahnen (12) umfasst, wobei sich die Leiterbahnen (12) jeweils zumindest teilweise über den ersten, den zweiten und den dritten Teilbereich (6, 6', 6") des Verbindungselements (4) erstrecken.

2. Modulgehäuse (1) nach Anspruch 1, **dadurch gekennzeichnet, dass** das Außengehäuse (3) einen Stecker (9) aufweist, welcher die elektrischen Steckerkontakte (8) zumindest teilweise umhüllt, wobei insbesondere verschiedene Formgebungen des elektrischen Steckerkontaktes (8) durch entsprechende Stanz-Biege-Prozesse realisierbar sind.

3. Modulgehäuse (1) nach einem der vorhergehenden Ansprüche, **dadurch gekennzeichnet, dass** das Verbindungselement (4) in dem dritten Teilbereich (6") eine elektrische und/oder mechanische Verbindung zu weiteren Steckerkontakten aufweist.

4. Modulgehäuse (1) nach einem der vorhergehenden Ansprüche, **dadurch gekennzeichnet, dass** das wenigstens eine Bauelement (5) einen elektrischen und/oder mechanischen ersten Kontakt (7) zum Verbindungselement (4) aufweist und/oder dass das Verbindungselement (4) in einem zweiten Teilbereich (6') formschlüssig von dem Außengehäuse (3) umschlossen ist.

5. Modulgehäuse (1) nach einem der vorhergehenden Ansprüche, **dadurch gekennzeichnet, dass** das Innengehäuse (2) und/oder das Außengehäuse (3) ein Moldgehäuse oder ein Spritzgussgehäuse und/oder dass das Bauelement wenigstens einen Halbleiterchip (10) und/oder wenigstens ein passives elektrisches Bauelement (11) umfassen, wobei das Moldgehäuse vorzugsweise ein Epoxidgehäuse oder ein Kunststoffgehäuse umfasst.

6. Verfahren zur Herstellung eines Modulgehäuses (1) nach einem der vorhergehenden Ansprüche, **dadurch gekennzeichnet, dass** in einem ersten Verfahrensschritt das wenigstens eine Bauelement (5) auf dem Verbindungselement (4) montiert wird, wobei in einem zweiten Verfahrensschritt das wenigstens eine Bauelement (5) und der erste Teilbereich (6) des Verbindungselements (4) zur Erzeugung des Innengehäuses (2) umspritzt wird und wobei in einem dritten Verfahrensschritt das Innengehäuse (2) und zumindest teilweise das Verbindungselement (4) zur Erzeugung des Außengehäuses (3) umspritzt wird.

7. Verfahren nach Anspruch 6, **dadurch gekennzeichnet, dass** zwischen dem ersten und dem zweiten Verfahrensschritt ein vierter Verfahrensschritt zum elektrischen Kontaktieren des wenigstens einen Bauelements (5), insbesondere mittels eines Bondvorgangs, durchgeführt wird.

8. Verfahren nach einem der Ansprüche 6 oder 7, **dadurch gekennzeichnet, dass** zwischen dem zweiten und dem dritten Verfahrensschritt ein fünfter Verfahrensschritt zum Stanzen und/oder Biegen des Verbindungselements (4), bevorzugt im dritten Teilbereich (6") des Verbindungselements zur Erzeugung der Steckerkontakte (8), durchgeführt wird.

9. Verfahren nach einem der Ansprüche 6 bis 8, **dadurch gekennzeichnet, dass**
im ersten Verfahrensschritt eine Vielzahl von Bauelementen (5) auf einen Verbund (4'), insbesondere einen Leadframe-Verband, montiert werden und dass im zweiten Verfahrensschritt die Vielzahl von Bauelementen zur Erzeugung einer Vielzahl von Innengehäusen (2) jeweils umspritzt werden, wobei im fünften Verfahrensschritt der Verbund (4') derart gestanzt wird, dass eine Vielzahl der Verbindungselemente (4) teilweise umschlossen von einem Innengehäuse (2) gebildet werden.

10. Verfahren nach einem der Ansprüche 6 bis 9, **dadurch gekennzeichnet, dass** der zweite Verfahrensschritt einen Moldprozess umfasst, wobei bevorzugt ein "injection molding"-Prozess durchgeführt wird und/oder der dritte Verfahrensschritt ein Spritzgussprozess umfasst, wobei bevorzugt ein Umspritzen mit einem Kunststoffprozess durchgeführt wird.

## Claims

1. Module housing (1) with an inner housing (2), an outer housing (3) and a connecting element (4), the inner housing (2) having at least one component (5) and being completely enclosed in a form-fitting manner by the outer housing (3), and the connecting element (4) being enclosed in a form-fitting manner by the inner housing (2) in a first partial region (6), **characterized in that** the connecting element (4) has electrical connector contacts (8) in a third partial region (6"), and **in that** the connecting element (4) comprises at least two electrically conductive interconnects (12), the interconnects (12) respectively extending at least partially over the first, the second and the third partial regions (6, 6', 6") of the connecting element (4).

2. Module housing (1) according to Claim 1, **characterized in that** the outer housing (3) has a connector (9), which at least partially envelops the electrical connector contacts (8), various shapings of the electrical connector contact (8) particularly being achievable by corresponding punching-bending processes.

3. Module housing (1) according to one of the preceding claims, **characterized in that** the connecting element (4) has an electrical and/or mechanical connection to further connector contacts in the third partial region (6").

4. Module housing (1) according to one of the preceding claims, **characterized in that** the at least one component (5) has an electrical and/or mechanical first contact (7) with respect to the connecting element (4) and/or **in that** the connecting element (4) is enclosed in a form-fitting manner by the outer housing (3) in a second partial region (6').

5. Module housing (1) according to one of the preceding claims, **characterized in that** the inner housing (2) and/or the outer housing (3) comprises a moulded housing or an injection-moulded housing and/or **in that** the component comprises at least one semiconductor chip (10) and/or at least one passive electrical component (11), the moulded housing preferably being an epoxy housing or a plastic housing.

6. Method for producing a module housing (1) according to one of the preceding claims, **characterized in that**, in a first method step, the at least one component (5) is mounted on the connecting element (4), in a second method step, the at least one component (5) and the first partial region (6) of the connecting element (4) are encapsulated to create the inner housing (2) and in a third method step, the inner housing (2) and at least partially the connecting element (4) are encapsulated to create the outer housing (3).

7. Method according to Claim 6, **characterized in that**, between the first and second method steps, a fourth method step is carried out for the electrical contacting of the at least one component (5), in particular by means of a bonding operation.

8. Method according to either of Claims 6 and 7, **characterized in that**, between the second and third method steps, a fifth method step is carried out, for the punching and/or bending of the connecting element (4), preferably in the third partial region (6 ") of the connecting element, to create the connector contacts (8).

9. Method according to one of Claims 6 to 8, **characterized in that**, in the first method step, a multiplicity of components (5) are mounted on a composite (4'), in particular a leadframe assembly, and **in that**, in the second method step, the multiplicity of components are respectively encapsulated to create a multiplicity of inner housings (2), while, in the fifth method step, the composite (4') is punched in such a way that a multiplicity of the connecting elements (4) are formed such that they are partially enclosed by an inner housing (2).

10. Method according to one of Claims 6 to 9, **characterized in that** the second method step comprises a moulding process, an injection-moulding process preferably being carried out and/or the third method step comprising an injection-moulding process, an encapsulation by a plastics process preferably being carried out.

## Revendications

1. Boîtier de module (1) comprenant un boîtier interne (2), un boîtier externe (3) et un élément de connexion (4), le boîtier interne (2) présentant au moins un composant (5) et étant entouré complètement par le boîtier externe (3) par engagement par correspondance géométrique, et l'élément de connexion (4) étant entouré dans une première région partielle (6) par le boîtier interne (2) par engagement par correspondance géométrique, **caractérisé en ce que** l'élément de connexion (4) présente dans une troisième région partielle (6") des contacts à fiches électriques (8), et **en ce que** l'élément de connexion (4) comprend au moins deux pistes conductrices électriquement conductrices (12), les pistes conductrices (12) s'étendant à chaque fois au moins en partie sur la première, deuxième et troisième région partielle (6, 6', 6") de l'élément de connexion (4).

2. Boîtier de module (1) selon la revendication 1, **caractérisé en ce que** le boîtier externe (3) présente un connecteur à fiches (9) qui enveloppe au moins en partie les contacts à fiches électriques (8), différentes formes du contact à fiches électrique (8) pouvant notamment être réalisées par des processus d'estampage-cintrage correspondants.

3. Boîtier de module (1) selon l'une quelconque des revendications précédentes, **caractérisé en ce que** l'élément de connexion (4) présente, dans la troisième région partielle (6"), une connexion électrique et/ou mécanique avec d'autres contacts à fiches.

4. Boîtier de module (1) selon l'une quelconque des revendications précédentes, **caractérisé en ce que** l'au moins un composant (5) présente un premier contact électrique et/ou mécanique (7) pour l'élément de connexion (4) et/ou **en ce que** l'élément de connexion (4) est entouré dans une deuxième région partielle (6') par engagement par correspondance géométrique par le boîtier externe (3) .

5. Boîtier de module (1) selon l'une quelconque des revendications précédentes, **caractérisé en ce que** le boîtier interne (2) et/ou le boîtier externe (3) comprennent un boîtier moulé ou un boîtier moulé par injection et/ou **en ce que** le composant comprend au moins une puce à semi-conducteur (10) et/ou au moins un composant électrique passif (11), le boîtier moulé comprenant de préférence un boîtier en époxy ou un boîtier en plastique.

6. Procédé pour fabriquer un boîtier de module (1) selon l'une quelconque des revendications précédentes, **caractérisé en ce que** dans une première étape de procédé, l'au moins un composant (5) est monté sur l'élément de connexion (4), dans une deuxième étape de procédé, l'au moins un composant (5) et la première région partielle (6) de l'élément de connexion (4) sont surmoulés en vue de produire le boîtier interne (2) et, dans une troisième étape de procédé, le boîtier interne (2) et au moins en partie l'élément de connexion (4) sont surmoulés pour produire le boîtier externe (3).

7. Procédé selon la revendication 6, **caractérisé en ce qu'**entre la première et la deuxième étape de procédé est mise en oeuvre une quatrième étape de procédé pour la mise en contact électrique de l'au moins un composant (5), notamment au moyen d'une opération de liaison.

8. Procédé selon l'une quelconque des revendications 6 ou 7, **caractérisé en ce qu'**entre la deuxième et la troisième étape de procédé est réalisée une cinquième étape de procédé pour l'estampage et/ou le cintrage de l'élément de connexion (4), de préférence dans la troisième région partielle (6") de l'élément de connexion pour produire les contacts à fiches (8).

9. Procédé selon l'une quelconque des revendications 6 à 8, **caractérisé en ce que**
dans la première étape de procédé, une pluralité de composants (5) sont montés sur un composite (4'), en particulier un assemblage de trame de fils, et **en ce que**, dans une deuxième étape de procédé, la pluralité de composants sont à chaque fois surmoulés pour produire une pluralité de boîtiers internes (2), et dans la cinquième étape de procédé, le composite (4') est estampé de telle sorte qu'une pluralité des éléments de connexion (4) sont formés de manière en partie entourée par un boîtier interne (2).

10. Procédé selon l'une quelconque des revendications 6 à 9, **caractérisé en ce que** la deuxième étape de procédé comprend un processus de moulage, un processus de moulage par injection étant de préférence mis en oeuvre, et/ou la troisième étape de procédé comprend un processus de moulage par injection, un surmoulage étant de préférence effectué avec un processus de moulage de plastique.
